# EUROPEAN PATENT APPLICATION

(11) **EP 4 694 647 A1**
(43) Date of publication of application: **11.02.2026**
(21) Application number: 23962743.3
(22) Date of filing: 29.12.2023
(51) Int. Cl.: H10K 59/35, H10K 59/38

(54) **DISPLAY PANEL AND DISPLAY APPARATUS**

(30) Priority: 26.12.2023 CN 202311813871
(71) Applicant: Wuhan China Star Optoelectronics Semiconductor Display Technology Co., Ltd., Wuhan, Hubei 430079 (CN)
(72) Inventor: HU, Kai, Wuhan, Hubei 430079 (CN)
(74) Representative: Zimmermann, Tankred Klaus
(86) International application number: PCT/CN2023/143043
(87) International publication number: WO 2025/138064

(57) **Abstract**

The present disclosure provides a display panel and a display device. A light-emitting device layer includes green light-emitting units. A green light emission spectrum of the green light-emitting units has a green light peak wavelength ranging between 495 nm and 530 nm. A color film layer includes green color resists covering the green light-emitting units. A transmission spectrum of the green color resists has a green light maximum transmittance wavelength ranging between 495 nm and 530 nm.

## Description

### TECHNICAL FIELD

The present disclosure relates to a technical field of display, and in particular to a display panel and a display device.

### BACKGROUND

Organic light-emitting diode (OLED) display devices have advantages of wide viewing angle, high contrast, and fast response, etc. However, the organic light-emitting diode display devices have insufficient blackness during screen rest, which affects a visual effect during screen rest.

Therefore, it is necessary to provide a technical solution to improve the technical problem of insufficient blackness of the organic light-emitting diode display devices during screen rest.

### SUMMARY

The present disclosure provides a display panel and a display device to improve the problem of insufficient blackness of the organic light-emitting diode display devices during screen rest.

In a first aspect, the present disclosure provides a display panel including a substrate layer, a light-emitting device layer, and a color film layer. The light-emitting device layer is disposed on the substrate layer. The light-emitting device layer includes light-emitting units, green light-emitting units, and blue light-emitting units arranged at intervals. A green light emission spectrum of the green light-emitting units has a green light peak wavelength ranging between 495 nm and 530 nm. The color film layer is disposed on a light-emitting side of the light-emitting device layer. The color film layer includes red color resists covering the red light-emitting units, green color resists covering the green light-emitting units, and blue color resists covering the blue light-emitting units. A transmission spectrum of the green color resists has a green light maximum transmittance wavelength ranging between 495 nm and 530 nm.

In a second aspect, the present disclosure further provides a display device including the display panel of any of some embodiments mentioned above.

### BENEFICIAL EFFECT

In the display panel and the display device of some embodiments of the present disclosure, a green light maximum transmittance wavelength of green color resists ranges between 495 nm and 530 nm. In this way, the green light maximum transmittance wavelength of the green color resists is shifted to a shorter wavelength direction, that is, the green light maximum transmittance wavelength of the green color resists is blue shifted. A distance between 555 nm and the green light maximum transmittance wavelength is larger, so that a transmittance of the green color resists to light of 555 nm decreases and an absorptivity increases. Accordingly, a reflectivity of the green color resists to the light of 555 nm is lower, a reflectivity of the display panel to the light of 555 nm during screen rest is reduced, and less light of 555 nm is reflected into human eyes, thereby improving a problem of insufficient blackness of the display panel during screen rest. At the same time, the green light peak wavelength ranges between 495 nm and 530 nm, so that the green light peak wavelength and the green light maximum transmittance wavelength are blue shifted together to reduce the distance between the green light maximum transmittance wavelength and the green light peak wavelength. A light intensity of the green light corresponding to the green light maximum transmittance wavelength is relatively larger to improve a brightness of green light when the display panel displays, which is conducive to reducing an overall power consumption of the display panel. Therefore, the display panels and the display devices provided by the embodiments of the present disclosure may have lower power consumption and may improve the problem of insufficient blackness during screen rest.

### BRIEF DESCRIPTION OF THE DRAWINGS

FIG. 1 is a cross-sectional structural schematic diagram of a display panel according to some embodiments of the present disclosure.
FIG. 2 is an emission spectrum of red light-emitting units, green light-emitting units, and blue light-emitting units and a transmittance spectrum of red color resists, green color resists, and red color resists according to some embodiments of the present disclosure.
FIG. 3 is a transmittance spectrum of the red color resists, the green color resists, and the red color resists according to other embodiments of the present disclosure.

### Reference numbers are as follows:

100, display panel;
11, substrate layer; 12, driving circuit layer; 13, pixel definition layer;
21, light-emitting device layer; 22, light-emitting unit; 23, red light-emitting unit; 231, red organic light-emitting layer; 232, first anode; 24, green light-emitting unit; 241, green organic light-emitting layer; 242, second anode; 25, blue light-emitting unit; 251, blue organic light-emitting layer; 252, third anode; 26. common cathode;
31, light filter layer; 32, color film layer; 321, red color resist; 322, green color resist; 323, blue color resist; 33, black matrix; 331, opening;
41, film encapsulation layer; 51, touching layer; 61, protective layer.

### DETAILED DESCRIPTION

The technical solutions in the embodiments of the present disclosure will be described clearly and completely hereafter with reference to the accompanying drawings. Apparently, the described embodiments are only a part of but not all embodiments of the present disclosure. All other embodiments obtained by persons of ordinary skill in the art based on the embodiments of the present disclosure without creative efforts shall fall within the protection scope of the present disclosure.

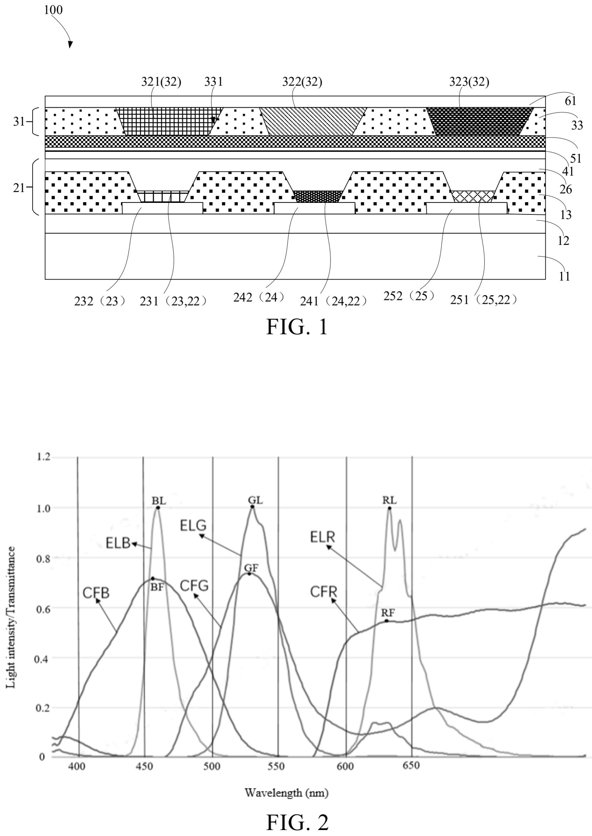

Referring to FIG. 1, FIG. 1 is a cross-sectional structural schematic diagram of a display panel according to some embodiments of the present disclosure. The display panel 100 includes a substrate layer 11, a light-emitting device layer 21, and a light filter layer 31.

The substrate layer 11 is used for support. The substrate layer 11 may be a glass substrate layer or a flexible substrate layer. In a specific embodiment, the substrate layer 11 may be a flexible substrate layer to make the display panel 100 bendable. The flexible substrate layer includes, but is not limited to, a polyimide layer.

The light filter layer 31 is not only used to reduce a reflectivity of ambient light to improve display contrast, but also may reduce a thickness of the display panel 100 to ensure that the display panel 100 may realize a flexible display. The light filter layer 31 is disposed on a light-emitting side of the light-emitting device layer 21.

Specifically, the light filter layer 31 is disposed on a side of the light-emitting device layer 21 facing away from the substrate layer 11. The light filter layer 31 includes a black matrix 33. The black matrix 33 includes a plurality of openings 331 going through the black matrix 33 in a thickness direction of the black matrix 33. The light filter layer 31 further includes a color film layer 32. The color film layer 32 includes red color resists 321, green color resists 322, and blue color resists 323 disposed in the plurality of openings 331, respectively.

Referring to FIG. 2, FIG. 2 is an emission spectrum of red light-emitting units, green light-emitting units, and blue light-emitting units and a transmittance spectrum of red color resists, green color resists, and red color resists according to some embodiments of the present disclosure.

A transmission spectrum CFG of the green color resists 322 has a green light maximum transmittance wavelength corresponding to an abscissa of a point GF on the transmission spectrum CFG of the green color resists 322. At the green light maximum transmittance wavelength, the transmission spectrum CFG of the green color resists 322 has a maximum transmittance corresponding to an ordinate of the point GF on the transmission spectrum CFG.

A transmission spectrum CFR of the red color resists 321 has a red light maximum transmittance wavelength corresponding to an abscissa of a point RF on the transmission spectrum CFR of the red color resists 321. At the red light maximum transmittance wavelength, the transmission spectrum CFR of the red color resists 321 has a maximum transmittance corresponding to an ordinate of the point RF on the transmission spectrum CFR.

A transmission spectrum CFB of the blue color resists 323 has a blue light maximum transmittance wavelength corresponding to an abscissa of a point BF on the transmission spectrum CFB of the blue color resists 323. At the blue light maximum transmittance wavelength, the transmission spectrum CFB of the blue color resists 323 has a maximum transmittance corresponding to an ordinate of the point BF on the transmission spectrum CFB.

The light-emitting device layer 21 is used for emitting light. The light-emitting device layer 21 includes a plurality of light-emitting units 22. The plurality of light-emitting units 22 include red light-emitting units 23, green light-emitting units 24, and blue light-emitting unit 25. The light-emitting units 22 may be selected any one from organic light-emitting diodes, micro light-emitting diodes (Micro-LED), sub-millimeter light-emitting diodes (mini-LED), and quantum dot light-emitting diodes, etc.

To describe the technical solution of the present disclosure, the plurality of light-emitting units 22 are all the organic light-emitting diodes, but are not limited thereto. Each of the red light-emitting units 23 includes a first anode 232, a common cathode 26, and a red organic light-emitting layer 231 therebetween. Each of the green light-emitting units 24 includes a second anode 242, the common cathode 26, and a green organic light-emitting layer 241 therebetween. Each of the blue light-emitting units 25 includes a third anode 252, the common cathode 26, and a blue organic light-emitting layer 251 therebetween. Therefore, the red light-emitting units 23, the green light-emitting units 24, and the blue light-emitting units 25 share the common cathode 26.

As shown in FIG. 1, the red color resists 321 cover the red light-emitting units 23, and an orthographic projection of the red color resists 321 on the substrate layer 11 overlaps an orthographic projection of the red light-emitting units 23 on the substrate layer 11. Specifically, an orthographic projection of the red organic light-emitting layer 231 on the substrate layer 11 is within the orthographic projection of the red color resists 321 on the substrate layer 11.

As shown in FIG. 2, a red light emission spectrum ELR of the red light-emitting units 23 has a red light peak wavelength corresponding to an abscissa of a point RL on the red light emission spectrum ELR of the red light-emitting units 23. At the red light peak wavelength, the red light emission spectrum ELR of the red light-emitting units 23 has a maximum light intensity corresponding to an ordinate of the point RL on the red light emission spectrum ELR.

As shown in FIG. 1, the green color resists 322 covers the green light-emitting units 24, and an orthographic projection of the green color resists 322 on the substrate layer 11 overlaps an orthographic projection of the green light-emitting units 24 on the substrate layer 11. Specifically, an orthographic projection of the green organic light-emitting layer 241 on the substrate layer 11 is within the orthographic projection of the green color resists 322 on the substrate layer 11.

As shown in FIG. 2, a green light emission spectrum ELG of the green light-emitting units 24 has a green light peak wavelength corresponding to an abscissa of a point GL on the green light emission spectrum ELG of the green light-emitting units 24. At the green light peak wavelength, the green light emission spectrum ELG of the green light-emitting units 24 has a maximum light intensity corresponding to an ordinate of the point GL on the green light emission spectrum ELG.

As shown in FIG. 1, the blue color resists 323 covers the blue light-emitting units 25, and an orthographic projection of the blue color resists 323 on the substrate layer 11 overlaps an orthographic projection of the blue light-emitting units 25 on the substrate layer 11. Specifically, an orthographic projection of the blue organic light-emitting layer 251 on the substrate layer 11 is within the orthographic projection of the blue color resists 323 on the substrate layer 11.

As shown in FIG. 2, a blue light emission spectrum ELB of the blue light-emitting units 25 has a blue light peak wavelength corresponding to an abscissa of a point BL on the blue light emission spectrum ELB of the blue light-emitting units 25. At the blue light peak wavelength, the blue light emission spectrum ELB of the blue light-emitting units 25 has a maximum light intensity corresponding to an ordinate of the point BL on the blue light emission spectrum ELB.

In a related art, a polarizer with a lower light transmittance is replaced by the color film layer with a higher light transmittance to improve a light-emitting efficiency of the display panel. However, removing the polarizer may lead to a high reflectivity of the display panel to the ambient light, resulting in insufficient blackness of the display panel during screen rest, which affects a visual effect during screen rest.

In view of the problem in the related art, in the present disclosure, when the human eyes are sensitive to light of 555 nm, a transmittance of the color film layer 32 to the light of 555 nm is reduced, so that an absorptivity of the color film layer 32 to the light of 555 nm is increased, the reflectivity of the light of 555 nm in the ambient light incident on the display panel 100 during screen rest on the color film layer 32 of the display panel 100 is decreased, and less light of 555 nm is reflected to the human eyes through the display panel 100 during screen rest, thereby improving the problem of the insufficient blackness of the display panel 100 during screen rest.

After analysis, it can be seen that since 555 nm is in a band of green light, by increasing a distance between 555 nm and the green light maximum transmittance wavelength, for example, the green light maximum transmittance wavelength is shifted to a shorter wavelength direction (blue shift), a transmittance of the green color resists 322 to the light of 555 nm may be reduced, and absorptivity of the green color resists 322 to the light of 555 nm is increased. Accordingly, a reflectivity of the green color resists to the light of 555 nm is lower, and a reflectivity of the color film layer 32 of the display panel 100 to the light of 555 nm is reduced, thereby improving the problem of insufficient blackness of the display panel 100 during screen rest. At the same time, in order to ensure that a light intensity of the green light maximum transmittance wavelength with the largest transmittance passing through the green color resists 322 is larger, a distance between the green light peak wavelength and the green light maximum transmittance wavelength needs to be smaller. In order to make the distance between the green light peak wavelength and the green light maximum transmittance wavelength smaller, the distance between 555 nm and the green light peak wavelength can also be increased, so that the green light peak wavelength can also be shifted to the shorter wavelength direction (blue shift) to increase the distance between 555 nm and the green light peak wavelength.

Specifically, in the present disclosure, as shown in FIG. 2, the green light maximum transmittance wavelength (corresponding to the abscissa of the point GF) ranges between 495 nm and 530 nm, and the green light peak wavelength (corresponding to the abscissa of the point GL) ranges between 495 nm and 530 nm. In this way, compared with the green light maximum transmittance wavelength greater than 530 nm (for example, any wavelength between 532 nm and 540 nm) in the related art, the green light maximum transmittance wavelength of the green color resists moves to the shorter wavelength direction, that is, the green light maximum transmittance wavelength of the green color resists is blue shifted. The distance between 555 nm and the green light maximum transmittance is larger, the transmittance of green color resists to the light of 555 nm decreases, and the absorptivity increases. Accordingly, the reflectivity of the green color resists to the light of 555 nm is lower, so that the reflectivity of the display panel to the light of 555 nm during screen rest is reduced, and less light of 555 nm is reflected into the human eyes, thereby improving the problem of insufficient blackness during screen rest.

At the same time, compared with the green light peak wavelength greater than 530 nm (for example, any wavelength between 532 nm and 540 nm) in the related art, the green light peak wavelength ranges between 495 nm and 530 nm, so that the green light peak wavelength and the green light maximum transmittance wavelength are blue shifted together to reduce the distance between the green maximum transmittance wavelength and the green peak wavelength. The light intensity of the green light corresponding to the green light maximum transmittance wavelength with the largest transmittance is larger, so that the brightness of the green light is improved when the display panel displays, which is conducive to reducing an overall power consumption of the display panel.

Therefore, the green light maximum transmittance wavelength ranges between 495 nm and 530 nm, and the green light peak wavelength ranges between 495 nm and 530 nm, so that the display panel provided by the embodiment of the present disclosure may have lower power consumption, and improve the problem of insufficient blackness during screen rest.

Optionally, the green light peak wavelength ranges between 500 nm and 525 nm. Optionally, the green light peak wavelength is greater than or equal to 505 nm and less than or equal to 520 nm. Optionally, the green light peak wavelength ranges between 508 nm and 515 nm. For example, the green light peak wavelength may be 495 nm, 498 nm, 500 nm, 502 nm, 505 nm, 508 nm, 510 nm, 512 nm, 515 nm, 518 nm, 520 nm, 522 nm, 525 nm, 528 nm, or 530 nm.

Optionally, the green light maximum transmittance wavelength ranges between 498 nm and 525 nm. Optionally, the green light maximum transmittance wavelength ranges between 502 nm and 523 nm. Optionally, the green light maximum transmittance wavelength is greater than or equal to 505 nm and less than or equal to 518 nm. Optionally, the green light maximum transmittance wavelength ranges between 508 nm and 515 nm. For example, the green light maximum transmittance wavelength may be 495 nm, 498 nm, 500 nm, 502 nm, 505 nm, 508 nm, 510 nm, 512 nm, 515 nm, 518 nm, 520 nm, 525 nm, 528 nm, or 530 nm.

In some embodiments, an absolute value of a difference between the green light peak wavelength and the green light maximum transmittance wavelength ranges between 0 nm and 15 nm. With this arrangement, the distance between the green light peak wavelength and the green light maximum transmittance wavelength is smaller, so that the light intensity of the green light corresponding to the green light maximum transmittance wavelength is larger. The green light corresponding to the green light maximum transmittance wavelength not only has the maximum transmittance passing through the green color resists 322, but also has a higher brightness, thereby further reducing the power consumption of the green light corresponding to the green light maximum transmittance wavelength. Optionally, the absolute value of the difference between the green light peak wavelength and the green light maximum transmittance wavelength ranges between 2 nm and 12 nm.

Optionally, the absolute value of the difference between the green light peak wavelength and the green light maximum transmittance wavelength ranges between 2 nm and 10 nm. Optionally, the absolute value of the difference between the green light peak wavelength and the green light maximum transmittance wavelength ranges between 3 nm and 8 nm. Optionally, the absolute value of the difference between the green light peak wavelength and the green light maximum transmittance wavelength ranges between 1 nm and 6 nm. Optionally, the absolute value of the difference between the green light peak wavelength and the green light maximum transmittance wavelength ranges between 2 nm and 5 nm.

In some embodiments, the green light peak wavelength is greater than or equal to the green light maximum transmittance wavelength. With this arrangement, a larger light intensity of the light corresponding to the green light maximum transmittance wavelength can be ensured, and the distance between the green light peak wavelength moving to the shorter wavelength direction can be reduced, thereby reducing the difficulty of manufacturing the green organic light-emitting layer 241.

In some embodiments, a difference between a sensitive wavelength of human eyes and the green light maximum transmittance wavelength is greater than or equal to 20 nm. A difference between the sensitive wavelength of human eyes and the green light peak wavelength is greater than or equal to 20 nm. The sensitive wavelength of human eyes ranges between 550 nm and 560 nm. With this arrangement, a distance between the sensitive wavelength of human eyes and the green light maximum transmittance wavelength is larger, so that a transmittance of the green color resists 322 to the light of the sensitive wavelength of human eyes is reduced, the absorptivity is increased, the reflectivity of the green color resists 322 to the light of the sensitive wavelength of human eyes is lower, and a reflectivity of the display panel 100 to the sensitive wavelength of human eyes is also reduced during screen rest. In a case where the human eyes are sensitive to the light of the sensitive wavelength of human eyes, the reflectivity of the display panel 100 to the light of the sensitive wavelength of human eyes is reduced, the light of the sensitive wavelength of human eyes reflected to the human eyes during screen rest is reduced, and less light of the sensitive wavelength of human eyes are reflected to the human eyes, thereby improving the problem of insufficient blackness during screen rest.

At the same time, with this arrangement mentioned above, a distance between the green light peak wavelength and the sensitive wavelength of human eyes also increases, so that the distance between the green light maximum transmittance wavelength and the green light peak wavelength is reduced. The green light peak wavelength and the green light maximum transmittance wavelength are blue shifted together, so that the light intensity of the green light corresponding to the green light maximum transmittance wavelength with the maximum transmittance is ensured, the brightness of the green light when the display panel 100 displays is increased, which is conducive to reducing the power consumption required for the display panel to emit the green light and the overall power consumption of the display panel 100.

Therefore, the difference between the sensitive wavelength of human eyes and the green light maximum transmittance wavelength is greater than or equal to 20 nm, and the difference between the sensitive wavelength of human eyes and the green light peak wavelength is greater than or equal to 20 nm, so that some embodiments of the display panel 100 provided in the present application may have lower power consumption and improve the problem of insufficient blackness during screen rest.

After further analysis, it can be seen that a distance between a minimum wavelength of red light and 555 nm is less than a distance between a maximum wavelength of blue light and 555 nm. Therefore, in this present disclosure, by increasing a distance between the red light maximum transmittance wavelength and the sensitive wavelength of human eyes, specifically, the red light maximum transmittance wavelength is shifted to a larger wavelength direction (red shift) to reduce a transmittance of the red color resists 321 to the sensitive wavelength of human eyes, thereby increasing an absorptivity of the red color resists 321 to the sensitive wavelength of human eyes. When the display panel 100 is in the rest screen state, the light of the sensitive wavelength of human eyes which is reflected and incident to the human eyes is further reduced, thereby improving the problem of insufficient blackness of the display panel 100 during screen rest. At the same time, in order to ensure the light intensity of the red light maximum transmittance wavelength, the red light peak wavelength may also be shifted along a larger wavelength direction, so that the distance between the red light maximum transmittance wavelength and the red light peak wavelength is smaller.

In some embodiments, the red light maximum transmittance wavelength ranges between 625 nm and 650 nm, and the red light peak wavelength ranges between 625 nm and 640 nm. In this way, compared with the red light maximum transmittance wavelength less than 625 nm in the related art, the red light maximum transmittance wavelength of the red color resists moves to the larger wavelength direction (red shift). Accordingly, the absorptivity of the red color resists 321 to the light of 555 nm is larger, and the reflectivity of the red color resists 321 to the light of 555 nm is lower, so that the reflectivity of color film layer 32 of the display panel 100 to the light of 555 nm during screen rest is reduced, and less light of 555 nm is reflected into the human eyes by the display panel 100 during screen rest, thereby improving the problem of insufficient blackness the of the display panel 100 during screen rest.

At the same time, compared with the red light peak wavelength less than 625 nm (for example, any wavelength between 620 nm and 624 nm) in the related art, the red light peak wavelength ranges between 625 nm and 640 nm, so that the red light peak wavelength and the red light maximum transmittance wavelength are red shifted together, and the distance between the red maximum transmittance wavelength and the red peak wavelength can be reduced, the light intensity of the red light corresponding to the red light maximum transmittance wavelength with the largest transmittance is larger, thereby increasing the brightness of the red light corresponding to the red light maximum transmittance wavelength, reducing the power consumption of the red light, and reducing the overall power consumption of the display panel.

Therefore, the red light maximum transmittance wavelength ranges between 625 nm and 650 nm, and the red light peak wavelength ranges between 625 nm and 640 nm, so that the red light maximum transmittance wavelength and the red light peak wavelength are red shifted, thereby further improving the problem of insufficient blackness during screen rest, and reducing the power consumption of the display panel.

Optionally, the red light maximum transmittance wavelength ranges between 628 nm and 648 nm. Optionally, the red light maximum transmittance wavelength ranges between 632 nm and 645 nm. Optionally, the red light maximum transmittance wavelength ranges between 635 nm and 645 nm. For example, the red light maximum transmittance wavelength can be 625 nm, 628 nm, 630 nm, 632 nm, 635 nm, 638 nm, 640 nm, 642 nm, 645 nm, 648 nm, or 650 nm.

Optionally, the red light peak wavelength ranges between 628 nm and 638 nm. Optionally, the red light peak wavelength ranges between 630 nm and 635 nm. For example, the red light peak wavelength may be 625 nm, 628 nm, 630 nm, 632 nm, 635 nm, 638 nm, or 640 nm.

In some embodiments, an absolute value of a difference between the red light maximum transmittance wavelength and the red light peak wavelength ranges between 0 nm and 15 nm. With this arrangement, the distance between the red light peak wavelength and the red light maximum transmittance wavelength is smaller, and the light intensity of the red light corresponding to the red light maximum transmittance wavelength is larger. The red light corresponding to the red light maximum transmittance wavelength not only has the maximum transmittance passing through the red color resists 321, but also has a higher brightness, thereby further reducing the power consumption of the red light corresponding to the red light maximum transmittance wavelength. Optionally, the absolute value of the difference between the red light peak wavelength and the red light maximum transmittance wavelength ranges between 2 nm and 12 nm. Optionally, the absolute value of the difference between the red light peak wavelength and the red light maximum transmittance wavelength is greater than or equal to 4 nm and less than or equal to 10 nm. Optionally, the absolute value of the difference between the red light peak wavelength and the red light maximum transmittance wavelength ranges between 6 nm and 8 nm. Optionally, the absolute value of the difference between the red light peak wavelength and the red light maximum transmittance wavelength is greater than or equal to 1 nm and less than or equal to 12 nm. Optionally, the absolute value of the difference between the red light peak wavelength and the red light maximum transmittance wavelength ranges between 2 nm and 6 nm.

In some embodiments, the absolute value of the difference between the red light maximum transmittance wavelength and the red light peak wavelength is greater than the absolute value of the difference between the green light peak wavelength and the green light maximum transmittance wavelength. With this arrangement, the absolute value of the difference between the green light peak wavelength and the green light maximum transmittance wavelength is much smaller, which is more conducive to improving the brightness of the green light corresponding to the green light maximum transmittance wavelength and further reducing the power consumption of the green light.

In other embodiments, the absolute value of the difference between the red light maximum transmittance wavelength and the red light peak wavelength may be less than the absolute value of the difference between the green light peak wavelength and the green light maximum transmittance wavelength. With this arrangement, the absolute value of the difference between the red light maximum transmittance wavelength and the red light peak wavelength is much smaller, which is more conducive to improving the brightness of the red light corresponding to the red light maximum transmittance wavelength and further reducing the power consumption of the red light. In some embodiments, a difference between the red light maximum transmittance wavelength and the sensitive wavelength of human eyes is greater than 80 nm, and a difference between the red light peak wavelength and the sensitive wavelength of human eyes is greater than 80 nm. With this arrangement, the distance between the red light maximum transmittance wavelength and the sensitive wavelength of human eyes is larger, so that the transmittance of the red color resists 321 to the light of the sensitive wavelength of human eyes is reduced. Correspondingly, the red color resists 321 has a larger absorptivity to the light of the sensitive wavelength of human eyes, so that the reflectivity of the red color resists 321 to the light of the sensitive wavelength of human eyes is lower. The reflectivity of the color film layer 32 of the display panel 100 during screen rest to the light of the sensitive wavelength of human eyes is further reduced, so that less light of the sensitive wavelength of human eyes is reflected by the display panel 100 during screen rest to the human eyes, thereby improving the problem of insufficient blackness of the display panel 100 during screen rest.

At the same time, the difference between the red light peak wavelength and the sensitive wavelength of human eyes is also larger, and the difference between the red light peak wavelength and the red light maximum transmittance wavelength is smaller, so that the light intensity of the red light corresponding to the red light maximum transmittance wavelength with the maximum transmittance is increased, and the brightness of the red light corresponding to the red light maximum transmittance wavelength is increased, which is conducive to improving to reducing the power consumption of the red light and further reducing the overall power consumption of the display panel 100.

Since the distance between blue light and the sensitive wavelength of human eyes is larger, reducing the transmittance of blue color resists 323 to the light of the sensitive wavelength of human eyes has little effect on reducing the reflectivity of blue color resists 323 to the light of the sensitive wavelength of human eyes. Therefore, in some embodiments of the present disclosure, the blue light peak wavelength and the blue light maximum transmittance wavelength may not be shifted, but are not limited thereto.

In some embodiments, the blue light peak wavelength ranges between 420 nm and 460 nm. Optionally, the blue light peak wavelength ranges between 425 nm and 458 nm. Optionally, the blue light peak wavelength ranges between 430 nm and 455 nm. Optionally, the blue light peak wavelength ranges between 435 nm and 445 nm. For example, the blue light peak wavelength may be 420 nm, 425 nm, 430 nm, 435 nm, 440 nm, 445 nm, 450 nm, 455 nm, or 460 nm.

In some embodiments, the blue light maximum transmittance wavelength ranges between 420 nm and 460 nm. Optionally, the blue light maximum transmittance wavelength ranges between 425 nm and 458 nm. Optionally, the blue light maximum transmittance wavelength ranges between 430 nm and 455 nm. Optionally, the blue light maximum transmittance wavelength ranges between 435 nm and 445 nm. For example, the blue light maximum transmittance wavelength can be 420 nm, 422 nm, 425 nm, 430 nm, 435 nm, 440 nm, 445 nm, 450 nm, 455 nm, or 460 nm.

In some embodiments, the blue light peak wavelength is greater than the blue maximum transmittance wavelength.

In some embodiments, an absolute value of a difference between the blue light peak wavelength and the blue maximum transmittance wavelength ranges between 0 nm and 15 nm. In this way, the light intensity of the blue light maximum transmittance wavelength with the largest transmittance may be increased, the brightness of the blue light maximum transmittance wavelength may be improved, which is conducive to reducing the light-emitting power consumption of the blue light, thereby reducing the overall power consumption of the display panel.

Optionally, the absolute value of the difference between the blue light peak wavelength and the blue maximum transmittance wavelength ranges between 1 nm and 12 nm. Optionally, the absolute value of the difference between the blue light peak wavelength and the blue maximum transmittance wavelength is greater than or equal to 2 nm and less than or equal to 10 nm. Optionally, the absolute value of the difference between the blue light peak wavelength and the blue maximum transmittance wavelength ranges between 3 nm and 8 nm.

In some embodiments, the absolute value of the difference between the blue light peak wavelength and the blue maximum transmittance wavelength is less than the absolute value of the difference between the green light peak wavelength and the green light maximum transmittance wavelength. With this arrangement, the absolute value of the difference between the blue light peak wavelength and the blue light maximum transmittance wavelength is much smaller, which is more conducive to improving the brightness of the blue light corresponding to the blue light maximum transmittance wavelength, thereby further reducing the power consumption of the blue light.

In a specific embodiment, as shown in FIG. 2, the abscissa of the point GF is from 523 nm to 528 nm, and the ordinate of the point GF is from 0.73 to 0.76. The abscissa of the point GL is from 528 nm to 530 nm, and the ordinate of the point GL is 1. The abscissa of the point RF is from 642 nm to 645 nm, and the ordinate of the point RF is from 0.57 to 0.58. The abscissa of the point RL is from 630 nm to 635 nm, and the ordinate of the point RL is 1. The abscissa of the point BF is from 453 nm to 457 nm, and the ordinate of the point BF is from 0.71 to 0.73. The abscissa of the point BL is from 455 nm to 460 nm, and the ordinate of the point BL is 1.

When the color film layer 32 and the light-emitting device layer 21 of the present disclosure are designed as shown in FIG. 2, the reflectivity of the display panel to light with a wavelength ranging between 380 nm and 780 nm is from 6.0% to 6.3%. That is, the display panel of the present disclosure has a lower emissivity of visible light, which can improve the problem of the insufficient blackness of the display panel during screen rest. At the same time, compared with that a brightness of white light emitted by the display panel is 365.47 nit in the related art, the brightness of white light emitted by the display panel of the present disclosure is 578.31 nit, so that the light-emitting efficiency of the display panel is improved by 58.23%, the brightness of the display panel is obviously improved, which is conducive to reducing the power consumption of the display panel.

Optionally, the reflectivity of the display panel for the light with the wavelength ranging between 380 nm and 780 nm is less than or equal to 6%. Optionally, the reflectivity of the display panel for the light with the wavelength ranging between 380 nm and 780 nm is less than or equal to 5.5%.

As can be seen from the foregoing, in this present disclosure, the green light peak wavelength and the green light maximum transmittance wavelength are simultaneously blue shifted, and the red light peak wavelength and the red light maximum transmittance wavelength are simultaneously red shifted, so as to reduce the reflectivity of the green color resists 322 and the red color resists 321 of the color film layer of the display panel to the light of the sensitive wavelength of human eyes in the ambient light, thereby reducing a flux of the light of the sensitive wavelength of human eyes in the ambient light incident to the human eyes and improving the problem of insufficient blackness of the display panel 100 during screen rest. At the same time, both the light intensity of the green light maximum transmittance wavelength and the light intensity of the red light maximum transmittance emitted by the display panel 100 are larger, and the brightness of the green light and the red light is improved, which is conducive to reducing the power consumption corresponding to the green light and the red light, thereby reducing the overall power consumption when the panel displays.

It should be noted that in this present disclosure, the green light peak wavelength is blue shifted, and the red light peak wavelength is red shifted, which can be realized by adjusting a material composition of the green organic light-emitting layer 241 and a material composition of the red organic light-emitting layer 231, respectively. The green light maximum transmittance wavelength is blue shifted, and the red light maximum transmittance wavelength is red shifted, which can be realized by adjusting a material composition of the green color resists 322 and a material composition of the red color resists 321, respectively.

It should further be noted that for monochromatic light, the sensitivity of the human eyes decreases in an order of the green light, the red light, and the blue light. Furthermore, due to the light-emitting materials themselves, a light-emitting efficiency of the green light is higher and a current of the green light is smaller, while the light-emitting efficiency of the blue light is lower and a current of the blue light is larger, which leads to larger power consumption of the blue light in the related art. In this present disclosure, it is possible to increase the light-emitting of the blue light to reduce the power consumption corresponding to the blue light, thereby further reducing the power consumption of the display panel 100.

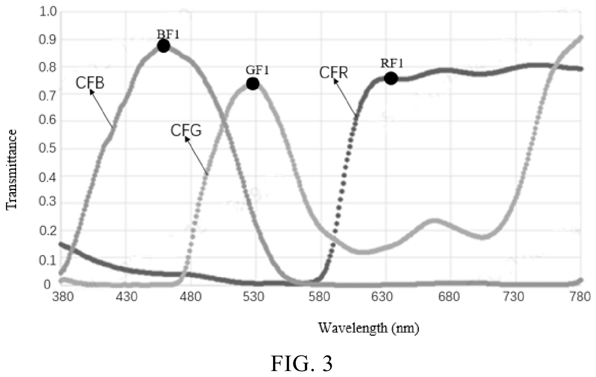

Referring to FIG. 3, FIG. 3 is a transmittance spectrum of the red color resists, the green color resists, and the red color resists according to other embodiments of the present disclosure.

As shown in FIG. 3, in some embodiments, the maximum transmittance of the transmission spectrum CFB of the blue color resists 323 is greater than the maximum transmittance of the transmission spectrum CFG of the green color resists 322. Specifically, the ordinate of the point BF1 of the transmission spectrum CFB of the blue color resists 323 in FIG. 3 is greater than the ordinate of the point GF1 of the transmission spectrum CFG of the green color resists 322 in FIG. 3. With this arrangement, the maximum transmittance of the blue light emitted by the blue light-emitting units 25 passing through the blue color resists 323 is larger, the brightness of the blue light is increased, and the power consumption of the blue light can be reduced. Furthermore, the maximum transmittance of the green light emitted by the green light-emitting units 24 passing through the green color resists 322 is relatively reduced, and correspondingly, the transmittance of the green color resists 322 to the light of the sensitive wavelength of human eyes is also reduced, the absorptivity of the green color resists 322 to the light of the sensitive wavelength of human eyes is increased, and the reflectivity of the green color resists 322 to the light of the sensitive wavelength of human eyes is reduced, thereby further reducing the reflectivity of the color film layer 32 to the light of the sensitive wavelength of human eyes, and further improving the problem of insufficient blackness of the display panel 100 during screen rest.

In some embodiments, the maximum transmittance of the transmission spectrum CFB of the blue color resists 323 is greater than the maximum transmittance of the transmission spectrum CFR of the red color resists 321. Specifically, the ordinate of the point BF1 of the transmission spectrum CFB of the blue color resists 323 in FIG. 3 is greater than the ordinate of the point RF1 of the transmission spectrum CFR of the red color resists 321 in FIG. 3. With this arrangement, the maximum transmittance of the red light emitted by the red light-emitting units 23 passing through the red color resists 321 is relatively reduced. Furthermore, the transmittance of the red color resists 321 to the sensitive wavelength of human eyes is also reduced, the absorptivity of the red color resists 321 to the light of the sensitive wavelength of human eyes is increased, the reflectivity of the red color resists 321 to the light of the sensitive wavelength of human eyes is reduced, and the reflectivity of the color film layer 32 to the light of the sensitive wavelength of human eyes is further reduced, thereby further improving the problem of insufficient blackness of the display panel 100 during screen rest.

In some embodiments, the maximum transmittance of the transmission spectrum CFB of the blue color resists 323 is greater than or equal to 0.6, the maximum transmittance of the transmission spectrum CFG of the green color resists 322 is greater than or equal to 0.45, and the maximum transmittance of the transmission spectrum CFR of the red color resists 321 is greater than or equal to 0.55. With this arrangement, the maximum transmittance of the transmission spectrum CFB of the blue color resists 323 is greater than the maximum transmittance of the transmission spectrum CFG of the green color resists 322 and the maximum transmittance of the transmission spectrum CFG of the red color resists 321.

In some embodiments, the maximum transmittance of the transmission spectrum CFB of the blue color resists 323 is less than or equal to 0.95. With this arrangement, the maximum transmittance of the blue color resists 323 to the blue light emitted by the blue light-emitting units 25 is increased, when the difficulty of manufacturing the blue color resists 323 is reduced.

Optionally, the maximum transmittance of the transmission spectrum CFB of the blue color resists 323 ranges between 0.65 and 0.9. Optionally, the maximum transmittance of the transmission spectrum CFB of the blue color resists 323 ranges between 0.7 and 0.85. Optionally, the maximum transmittance of the transmission spectrum CFB of the blue color resists 323 ranges between 0.72 and 0.8.

In some embodiments, the maximum transmittance of the transmission spectrum CFG of the green color resists 322 is less than or equal to 0.75. With this arrangement, the maximum transmittance of the green light emitted by the green light-emitting units 24 passing through the green color resists 322 is relatively smaller, the transmittance of the green color resists 322 to the light of the sensitive wavelength of human eyes is reduced, and the reflectivity of the green color resists 322 to the light of the sensitive wavelength of human eyes is reduced, thereby further reducing the reflectivity of the color film layer 32 of the display panel 100 during screen rest to the light of the sensitive wavelength of human eyes, reducing the light of the sensitive wavelength of human eyes incident to the human eyes, and improving the problem of insufficient blackness of the display panel 100 during screen rest.

Optionally, the maximum transmittance of the transmission spectrum CFG of the green color resists 322 ranges between 0.5 and 0.75. Optionally, the maximum transmittance of the transmission spectrum CFG of the green color resists 322 ranges between 0.55 and 0.72. Optionally, the maximum transmittance of the transmission spectrum CFG of the green color resists 322 ranges between 0.58 and 0.71.

In some embodiments, the maximum transmittance of the transmission spectrum CFR of the red color resists 321 is less than or equal to 0.75. With this arrangement, the maximum transmittance of the transmission spectrum CFR of the red color resists 321 is relatively smaller, the transmittance of the red color resists 321 to light of the sensitive wavelength of human eyes is reduced, the reflectivity of the red color resists 321 to light of the sensitive wavelength of human eyes is reduced, and the light of the sensitive wavelength of human eyes incident to the human eyes is reduced, thereby improving the problem of insufficient blackness of the display panel 100 during screen rest.

Optionally, the maximum transmittance of the transmission spectrum CFR of the red color resists 321 ranges between 0.6 and 0.75. Optionally, the maximum transmittance of the transmission spectrum CFR of the red color resists 321 ranges between 0.65 a and 0.72.

As shown in FIG. 3, in a specific embodiment, the green light maximum transmittance wavelength corresponding to the abscissa of the point GF1 is from 528 nm to 530 nm, and the maximum transmittance of transmission spectrum CFG of the green color resists 322 corresponding to the ordinate of the point GF1 is from 0.71 to 0.74. The blue light maximum transmittance wavelength corresponding to the abscissa of the point BF1 is from 448 nm to 452 nm, and the maximum transmittance of transmission spectrum CFB of the blue color resists 323 corresponding to the ordinate of the point BF1 is from 0.85 to 0.9. The red light maximum transmittance wavelength corresponding to the abscissa of the point RF1 is from 630 nm to 632 nm, and the maximum transmittance of transmission spectrum CFR of the red color resists 321 corresponding to the ordinate of the point RF1 is from 0.71 to 0.74.

As shown in FIG. 1, the display panel 100 further includes a driving circuit layer 12 disposed between the light-emitting device layer 21 and the substrate layer 11. The driving circuit layer 12 includes pixel driving circuits connected to the light-emitting unit 22 in one-to-one correspondence. The pixel driving circuits may be any one of a 2T1C circuit, a 3T1C circuit, a 4T1C circuit, a 5T1C circuit, a 6T1C circuit, and a 7T1C circuit. Where T refers to a thin film transistor and C refers to a capacitor. 7T refers to seven thin film transistors and 1C refers to one capacitor.

The display panel 100 further includes a pixel definition layer 13 disposed on the driving circuit layer 12 and includes a plurality of openings. The red organic light-emitting layer 231, the green organic light-emitting layer 241, and the blue organic light-emitting layer 251 are all disposed in the openings. A common cathode 26 is disposed on the pixel definition layer 13, the red organic light-emitting layer 231, the green organic light-emitting layer 241, and the blue organic light-emitting layer 251.

In some embodiments, the display panel 100 further includes a thin film encapsulation layer 41 used to block water vapor and oxygen to improve erosion of the organic light-emitting layer by water vapor and oxygen. The thin film encapsulation layer 41 includes two inorganic insulating layers and an organic insulating layer located between the two inorganic insulating layers. A material of the inorganic insulating layers includes at least one of silicon nitride, silicon oxide, and silicon oxynitride. A material of the organic insulating layer includes at least one of polyacrylate and polysiloxane.

In some embodiments, the thin film encapsulation layer 41 may be located between the light-emitting device layer 21 and the color film layer 32. In other embodiments, the color film layer 32 may also be disposed between the thin film packaging layer 41 and the light-emitting device layer 21. In other embodiments, the color film layer 32 may also be disposed inside the film encapsulation layer 41.

In some embodiments, the display panel 100 further includes a touching layer 51. The touching layer 51 may include self-capacitance touching electrodes or mutual-capacitance touching electrodes. The touching layer 51 may be disposed between the film encapsulation layer 41 and the color film layer 32, and the color film layer 32 is located on a side of the touching layer 51 facing away from the substrate layer 11. The touching layer 51 may also be integrated into the driving circuit layer 12. The color film layer 32 may also be integrated into the touching layer 51.

In a specific embodiment, the touching layer 51 is disposed between the film encapsulation layer 41 and the color film layer 32, and the color film layer 32 is located on the side of the touching layer 51 facing away from the substrate layer 11.

In some embodiments, the display panel 100 further includes a protective layer 61 located on a side of the color film layer 32 facing away from the substrate layer 11. The protective layer 61 is used for protecting and flattening the color film layer 32. A material of the protective layer 61 includes organic materials.

Based on the same inventive concept, the present disclosure further provides a display device including the display panel 100 of any of the embodiments mentioned above. The display device may be applied to electronic devices such as mobile phones, tablet computers, and personal computers.

The description about the foregoing embodiments is merely provided to help understand the method and core ideas of the present disclosure. Persons of ordinary skill in the art should understand that they may still make modifications to the technical solutions described in the foregoing embodiments or make equivalent replacements to some or all technical features thereof, without departing from the scope of the technical solutions of the embodiments of the present disclosure.

## Claims

1. A display panel, comprising:
a substrate layer;
a light-emitting device layer disposed on the substrate layer and comprising red light-emitting units, green light-emitting units, and blue light-emitting units arranged at intervals, wherein a green light emission spectrum of the green light-emitting units has a green light peak wavelength ranging between 495 nm and 530 nm; and
a color film layer disposed on a light-emitting side of the light-emitting device layer, wherein the color film layer comprises red color resists covering the red light-emitting units, green color resists covering the green light-emitting units, and blue color resists covering the blue light-emitting units, and a transmission spectrum of the green color resists has a green light maximum transmittance wavelength ranging between 495 nm and 530 nm.

2. The display panel according to claim 1, wherein an absolute value of a difference between the green light peak wavelength and the green light maximum transmittance wavelength ranges between 0 nm and 15 nm.

3. The display panel according to claim 1, wherein a transmission spectrum of the red color resists has a red light maximum transmittance wavelength ranging between 625 nm and 640 nm; and
wherein a transmission spectrum of the red color resists has a red light maximum transmittance wavelength ranging between 625 nm and 650 nm.

4. The display panel according to claim 3, wherein an absolute value of a difference between the red light peak wavelength and the red light maximum transmittance wavelength ranges between 0 nm and 15 nm.

5. The display panel according to claim 1, wherein a maximum transmittance of a transmission spectrum of the blue color resists is greater than a maximum transmittance of the transmission spectrum of the green color resists.

6. The display panel according to claim 5, wherein the maximum transmittance of the transmission spectrum of the blue color resists is greater than a maximum transmittance of a transmission spectrum of the red color resists.

7. The display panel according to claim 1, wherein a maximum transmittance of a transmission spectrum of the blue color resists is greater than or equal to 0.6, a maximum transmittance of the transmission spectrum of the green color resists is greater than or equal to 0.45, and a maximum transmittance of a transmission spectrum of the red color resists is greater than or equal to 0.55.

8. The display panel according to claim 7, wherein the maximum transmittance of the transmission spectrum of the blue color resists is less than or equal to 0.95, the maximum transmittance of the transmission spectrum of the green color resists is less than or equal to 0.75, and the maximum transmittance of the transmission spectrum of the red color resists is less than or equal to 0.75.

9. The display panel according to claim 1, wherein a blue light emission spectrum of the blue light-emitting units has a blue light peak wavelength ranging between 420 nm and 460 nm; and
wherein a transmission spectrum of the blue color resists has a blue light maximum transmittance wavelength ranging between 420 nm and 460 nm.

10. The display panel according to claim 1, wherein a reflectivity of the display panel to light ranging between 380 nm and 780 nm is less than or equal to 6.3%.

11. A display device, comprising a display panel, wherein the display panel comprises:
a substrate layer;
a light-emitting device layer disposed on the substrate layer and comprising red light-emitting units, green light-emitting units, and blue light-emitting units arranged at intervals, wherein a green light emission spectrum of the green light-emitting units has a green light peak wavelength ranging between 495 nm and 530 nm; and
a color film layer disposed on a light-emitting side of the light-emitting device layer, wherein the color film layer comprises red color resists covering the red light-emitting units, green color resists covering the green light-emitting units, and blue color resists covering the blue light-emitting units, and a transmission spectrum of the green color resists has a green light maximum transmittance wavelength ranging between 495 nm and 530 nm.

12. The display device according to claim 11, wherein an absolute value of a difference between the green light peak wavelength and the green light maximum transmittance wavelength ranges between 0 nm and 15 nm.

13. The display device according to claim 11, wherein a transmission spectrum of the red color resists has a red light maximum transmittance wavelength ranging between 625 nm and 640 nm; and
wherein a transmission spectrum of the red color resists has a red light maximum transmittance wavelength ranging between 625 nm and 650 nm.

14. The display device according to claim 13, wherein an absolute value of a difference between the red light peak wavelength and the red light maximum transmittance wavelength ranges between 0 nm and 15 nm.

15. The display device according to claim 11, wherein a maximum transmittance of a transmission spectrum of the blue color resists is greater than a maximum transmittance of the transmission spectrum of the green color resists.

16. The display device according to claim 15, wherein the maximum transmittance of the transmission spectrum of the blue color resists is greater than a maximum transmittance of a transmission spectrum of the red color resists.

17. The display device according to claim 11, wherein a maximum transmittance of a transmission spectrum of the blue color resists is greater than or equal to 0.6, a maximum transmittance of the transmission spectrum of the green color resists is greater than or equal to 0.45, and a maximum transmittance of a transmission spectrum of the red color resists is greater than or equal to 0.55.

18. The display device according to claim 17, wherein the maximum transmittance of the transmission spectrum of the blue color resists is less than or equal to 0.95, the maximum transmittance of the transmission spectrum of the green color resists is less than or equal to 0.75, and the maximum transmittance of the transmission spectrum of the red color resists is less than or equal to 0.75.

19. The display device according to claim 11, wherein a blue light emission spectrum of the blue light-emitting units has a blue light peak wavelength ranging between 420 nm and 460 nm; and
wherein a transmission spectrum of the blue color resists has a blue light maximum transmittance wavelength ranging between 420 nm and 460 nm.

20. The display device according to claim 11, wherein a reflectivity of the display panel to light ranging between 380 nm and 780 nm is less than or equal to 6.3%.
